Europäisches Patentamt

European Patent Office

Office européen des brevets

(19)

(11) Numéro de publication : **0 497 068 A1**

(12) **DEMANDE DE BREVET EUROPEEN**

(21) Numéro de dépôt : **91403333.7**

(22) Date de dépôt : **09.12.91**

(51) Int. Cl.⁵ : **H03K 17/30, H03K 3/353**

(30) Priorité : **14.12.90 FR 9015722**

(43) Date de publication de la demande :
**05.08.92 Bulletin 92/32**

(84) Etats contractants désignés :
**BE CH DE ES FR GB IT LI NL SE**

(71) Demandeur : **BULL S.A.**
**121, Avenue de Malakoff**
**F-75116 Paris (FR)**

(72) Inventeur : **Neu, Georges**
**121, avenue de Malakoff, PC 8M006**
**F-75116 Paris (FR)**
Inventeur : **Ahn, Claude**
**121, avenue de Malakoff, PC 8M006**
**F-75116 Paris (FR)**

(74) Mandataire : **Denis, Hervé et al**
**121, avenue de Malakoff, PC 8M006**
**F-75116 Paris (FR)**

(54) **Circuit à seuil.**

(57)  Le circuit à seuil comprend un dispositif de commutation 10 à seuil à multiples configurations de déclenchement, chaque configuration de déclenchement correspondant à un seuil distinct étant activée sélectivement par un circuit pilote 16. Le circuit 10 est constitué par un montage parallèle de transistors PMOS (P1, P2) et NMOS (N1, N2) commandés par le signal d'entrée E et dont certains (P2, N2) sont mis alternativement en/hors service à partir du circuit de pilotage 16.

L'invention est surtout avantageuse en association avec une ligne de transmission de signaux entre circuits intégrés CMOS de type VLSI, ou avec des liaisons intérieures ou extérieures fortement capacitives.

FIG. 1

La présente invention concerne un circuit électronique à seuil particulièrement adapté à une intégration de type VLSI (Very Large Scale Integration) et utilisable notamment en association avec des lignes électriques de transmission de signaux entre circuits intégrés ou avec des liaisons intérieures ou extérieures de forte capacité.

Les liaisons électriques reliant un circuit intégré à un composant extérieur, un autre circuit intégré par exemple, peuvent constituer de véritables lignes électriques pour les signaux de très haute fréquence actuellement utilisés. Un signal, par exemple de forme rectangulaire, est susceptible d'être déformé selon la position du point de branchement sur la ligne, la longueur de celle-ci (définissant le temps de propagation θ de l'onde parcourant toute la ligne) et l'équilibrage électrique de la ligne. Si, à l'autre extrémité de la ligne, le signal demeure rectangulaire mais décalé du temps θ , la réflexion de l'onde en bout de ligne entraîne la formation d'un gradin d'une durée maximale de 2 θ pour le signal présent sur la ligne en un point intermédiaire. Selon l'équilibrage de la ligne, la tension correspondante à ce gradin est susceptible de varier autour de la position à mi-hauteur du front du signal correspondant à la tension d'alimentation du circuit. Cette situation est gênante en ce qu'elle entraîne une imprécision au niveau de l'instant de déclenchement des circuits récepteurs avec parfois des retards importants et inacceptables pour beaucoup d'applications actuelles des circuits intégrés. En particulier, les circuits à seuil disposés à l'entrée de circuits intégrés et destinés à remettre en forme les signaux reçus avant leur exploitation ultérieure sont souvent constitués par des amplificateurs à seuil centré (c'est-à-dire dont le seuil de déclenchement est choisi à mi-hauteur de la tension d'alimentation) pour être utilisés avec la même efficacité lors d'un passage d'un front montant ou d'un front descendant d'un signal de transmission. De tels circuits sont très sensibles à ce phénomène d'établissement de signal en gradin.

Par ailleurs, certaines liaisons électriques peuvent présenter une capacité électrique suffisamment importante pour accroître très sensiblement la durée d'établissement des fronts (montant ou descendant) des signaux transmis. Il en résulte une augmentation importante du temps nécessaire pour atteindre le seuil de déclenchement de l'amplificateur.

A l'inverse, certains circuits demandent non plus un déclenchement précoce mais au contraire un déclenchement tardif. Un exemple d'application de tels circuits à déclenchement tardif est donné dans la demande de brevet européen EP 0.373.043.

L'invention a pour but de contrôler avec précision le niveau de seuil et par là-même l'instant de déclenchement d'un circuit à seuil.

A cet effet, l'invention propose un circuit à seuil comportant un dispositif de commutation à seuil à multiples configurations de déclenchement, chaque configuration de déclenchement, correspondant à un seuil de déclenchement distinct (S1, S2), étant activée sélectivement par un circuit pilote.

Ainsi, l'activation d'un seuil parmi une multiplicité de seuils de déclenchement permet l'adaptation du circuit à seuil aux autres circuits auxquels il est associé.

Chaque configuration peut correspondre à une activation sélective des transistors à effet de champ du dispositif de commutation. De préférence, les valeurs de seuil sont déterminées par les rapports correspondants des largeurs électriques équivalentes des grilles des transistors à effet de champ du dispositif de commutation.

Selon un mode de réalisation, les transistors à effet de champ sont disposés dans au moins deux branches parallèles et le circuit pilote commande l'activation sélective des transistors à effet de champ et/ou des branches du dispositif de commutation. Celui-ci est avantageusement du type inverseur à transistors à effet de champ complémentaires.

Selon un mode de réalisation préféré de l'invention, le dispositif de commutation à multiples configurations de déclenchement comprend une pluralité de transistors de déclenchement PMOS commandés par le signal d'entrée E et montés en parallèle sur un premier jeu de branches disposées entre une source de tension VDD et la sortie S du circuit à seuil, au moins une des branches du premier jeu étant pourvue d'un transistor de configuration PMOS commandé par le circuit pilote, et une pluralité de transistors de déclenchement NMOS commandés par le signal d'entrée E et montés en parallèle sur un second jeu de branches disposées entre la masse du circuit et la sortie S du circuit à seuil, au moins une des branches du second jeu étant pourvue d'un transistor de configuration NMOS commandé par le circuit pilote.

Selon un autre aspect de l'invention, le circuit pilote est de préférence commandé par le signal d'entrée E. Avantageusement, le circuit à seuil présente deux configurations de déclenchement respectivement aux seuils S1 et S2, avec S1 supérieur à S2, activées alternativement par le circuit pilote, ledit circuit pilote changeant la configuration activée à chaque passage d'un front du signal E. Cette caractéristique permet d'obtenir la même efficacité dans l'effet recherché (précoce ou tardif) lors du passage d'un front montant ou d'un front descendant du signal E.

Selon encore un autre aspect de l'invention, le circuit pilote est du type à hystérésis, par exemple du type à bascule de Schmitt. Avantageusement, le circuit pilote bascule au passage du front montant FM du signal E à un seuil "haut" VBM supérieur au plus haut (S1) des seuils de déclenchement dudit dispositif à multiples configurations de déclenchement et au passage du front descendant FD du signal E à un seuil "bas" VBD inférieur au plus bas S2 des seuils de déclenchement dudit dispositif à multiples configurations de déclenchement.

Selon encore un autre aspect de l'invention, le circuit pilote comporte une ligne de commande pour activer les configurations dudit dispositif à multiples configurations, la ligne de commande étant pourvue de moyens inverseurs de signal mis en ou hors service par un premier jeu d'interrupteurs commandés par une première ligne de commande LCB. Cette caractéristique est intéressante dans le cas de conditions d'utilisation délicates et changeantes du circuit à seuil où il peut être souhaitable de changer de mode de déclenchement, mode précoce vers mode tardif ou inversement. Avantageusement le circuit à seuil comporte également un dispositif à seuil centré et des moyens de sélection constitués d'un second jeu d'interrupteurs commandés par une seconde ligne de commande LCA pour mettre en service sélectivement le dispositif à multiples configurations de déclenchement ou le dispositif à seuil centré. Cette variante permet d'obtenir trois niveaux de seuils de déclenchement.

Les caractéristiques et avantages de la présente invention apparaîtront à la lecture de la description qui va suivre et qui se réfère aux dessins ci-annexés dans lesquels :

- la figure 1 est une représentation schématique d'un premier mode de réalisation d'un circuit à seuil selon l'invention ; et
- la figure 2 est une représentation schématique d'un second mode de réalisation d'un circuit à seuil selon l'invention.

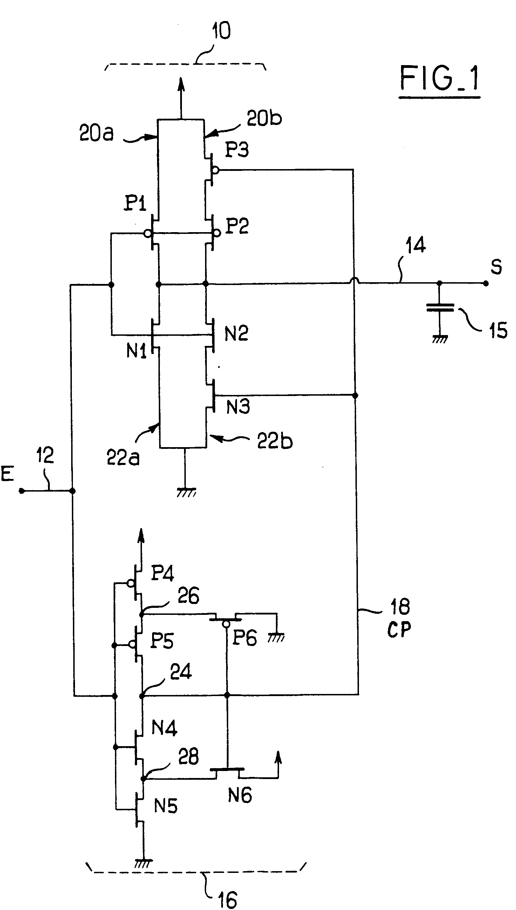

Le circuit à seuil de l'invention qui est illustré schématiquement dans la figure 1 comprend un dispositif de commutation à seuil à multiples configurations 10 recevant des signaux d'entrée E à partir d'une ligne d'entrée 12 et produisant des signaux de sortie S sur une ligne de sortie 14 protégée par une capacité de découplage 15. Le dispositif de commutation présente plusieurs configurations de déclenchement correspondant chacune à un seuil de déclenchement distinct et qui sont activées sélectivement, par l'intermédiaire d'une ligne de commande CP 18, par un circuit pilote 16 commandé par le signal d'entrée E issu de la ligne 12.

Le dispositif de commutation à seuil 10 comprend une pluralité de transistors de déclenchement PMOS, P1, P2 dont les grilles sont connectées à la ligne d'entrée 12. Les transistors de déclenchement P1, P2 sont montés en parallèle sur un premier jeu de branches 20a et 20b disposées entre une source de tension VDD et la ligne de sortie 14 du circuit à seuil. De plus, une des branches, la branche 20b, est pourvue d'un transistor de configuration PMOS P3 monté en série avec le transistor P2 et dont la grille est connectée à la ligne de commande 18. De façon semblable, le dispositif de commutation à seuil 10 comprend une pluralité de transistors de déclenchement NMOS, N1, N2 dont les grilles sont connectées à la ligne d'entrée 12. Les transistors de déclenchement N1, N2 sont montés en parallèle sur un second jeu de branches 22a et 22b disposées entre la ligne de sortie 14 et la masse du circuit. De plus, l'une des branches, la branche 22b, est pourvue d'un transistor de configuration NMOS N3 monté en série avec le transistor N2 et dont la grille est connectée à la ligne de commande 18.

Le dispositif de commutation à seuil, qui vient d'être décrit à titre d'exemple non limitatif, est conçu pour présenter deux configurations de déclenchement activées de façon sélective par l'intermédiaire de la ligne 18. Toutefois, sans sortir du cadre de l'invention, des variantes de circuits à seuil non représentées peuvent présenter un nombre plus important de configurations par addition de branches de type PMOS 20 et/ou de type NMOS 22, équipées d'un transistor de déclenchement et de moyens de configuration.

Le circuit pilote 16 est du type à hystérésis tel qu'une bascule de Schmitt dans l'exemple illustré à la figure 1. Cette bascule comporte de manière classique en premier rang, entre VDD et la masse, un montage série de deux transistors PMOS appariés P4 et P5 suivis de deux transistors NMOS appariés N4 et N5. Les grilles des quatre transistors MOS de premier rang reçoivent le signal de transmission E. La sortie 24 du circuit pilote prise entre les drains des transistors de premier rang PMOS P5 et NMOS N4 adjacents est reliée aux grilles de deux transistors respectivement PMOS P6 et NMOS N6 de second rang. La sortie 24 est également connectée à la ligne de commande 18. Comme illustré à la figure 1, le drain de chaque transistor MOS de second rang P6 et N6 est connecté à la borne de jonction 26 (transistor P) et 28 (transistors N) entre les deux transistors MOS de premier rang de même polarité P ou N. Leurs sources sont respectivement mises à la masse et à VDD. Le fonctionnement de la bascule 16 est bien connu.

Le mode opératoire du circuit représenté à la figure 1 va maintenant être présenté. Au repos, le signal E est au niveau "0", les transistors de déclenchement NMOS N1 et N2 sont bloqués tandis que les transistors de déclenchement PMOS P1 et P2 sont passants. Ainsi le drain du transistor P1 est porté à la tension VDD et la ligne de sortie 14 est au niveau "1". En ce qui concerne le circuit pilote 16, toutes les grilles des transistors du premier rang sont portées au niveau "0". Il en résulte que les deux transistors P4 et P5 sont passants et les deux transistors NMOS sont N4 et N5 sont bloqués. La sortie 24 du circuit pilote 16 est ainsi portée au niveau "1". Dans ces conditions, les transistors P6 et N6 sont bloqués. Cependant, le transistor N6 est susceptible de conduire, après le déblocage du transistor N5 lorsque le signal E est porté au niveau "1". Il en résulte que

3

EP 0 497 068 A1

jusqu'au basculement du circuit de pilotage 16, la ligne de commande 18 est maintenue au niveau "1" (CP = "1"). Le transistor de configuration P3 est alors bloqué tandis que le transistor de configuration N3 est passant.

D'une façon générale, les circuits présentés ci-dessus commutent à des valeurs de seuil de déclenchement qui dépendent, outre de l'architecture même du circuit, des caractéristiques physiques des transistors MOS qui les composent, tout particulièrement des largeurs électriques des grilles des transistors. Le circuit pilote à hystérésis 16 bascule à chaque passage d'un front (montant ou descendant) du signal de transmission E, pour des tensions de basculement en montée VBM et en descente VBD respectivement situées au voisinage des niveaux "haut" ou "1" et "bas" ou "0" du signal de transmission. Pour le dispositif de commutation à seuil 10, l'état de la ligne de commande 18, CP="1" ou CP="0", permet la sélection et l'activation de l'une des deux configurations. Plus particulièrement pour CP="1", le transistor de configuration P3 bloqué met hors service la branche 20b du dispositif de commutation 10, qui prend la configuration 20a/22a-22b. Dans cette configuration le seuil de basculement S2 est situé à un niveau de tension assez bas mais encore supérieur au niveau VBD du circuit pilote 16. Dans cette configuration, le montage en parallèle des deux branches 22a et 22b équipées de leurs transistors de type N présente une résistance équivalente plus faible par rapport à celle de la seule branche 22a. Ceci explique l'abaissement du seuil de commutation S2 par rapport à un circuit inverseur classique de type P1/N1. De façon semblable, pour CP="0", le transistor de configuration N3 bloqué met hors service la branche 22b du dispositif de commutation 10, qui prend alors la configuration 20a-20b/22a. Dans cette configuration le seuil de basculement S1 (S1>S2) est situé à un niveau de tension assez élevé mais encore inférieur au niveau VBD du circuit pilote 16. Dans cette configuration, le montage en parallèle des deux branches 20a et 20b équipées de leurs transistors de type N présente une résistance équivalente plus faible par rapport à celle de la seule branche 20a. Ceci explique le relèvement du seuil de commutation S1 par rapport à un circuit inverseur classique du type P1/N1.

Cette disposition VBD<S2<S1<VBM permet d'éviter des oscillations indésirables de S par retour prématuré au niveau antérieur au déclenchement sur le passage d'un même front (montant ou descendant) du signal E, ce que provoquerait un changement de configuration du circuit à seuil de la figure 1 pour un niveau de tension compris entre S1 et S2.

Par conséquent, lors du front montant du signal E, lorsque la tension de grille connectée à la ligne 12 atteint la valeur S2, le transistor P1 se bloque tandis que les trois transistors N1, N2 et N3 sont passants. Le déclenchement du dispositif de commutation 10 intervient alors et la sortie S sur la ligne 14 est portée au niveau "0". Compte tenu du niveau assez bas du seuil S2 proche du niveau "bas" du signal E, le déclenchement du dispositif de commutation 10 intervient de façon précoce au passage du front montant du signal E. Comme annoncé précédemment, le circuit de pilotage 16 commute lorsque le front du signal E a atteint la valeur VBM. La conduction des transistors NMOS N4 et N5 forme un pont résistif diviseur. Le niveau VBM est alors très proche de VBD, en fait simplement séparé de VBD de la valeur de la tension de seuil Vt du transistor N4 (de l'ordre de 0,5 volt). La ligne de commande 18 prend alors la valeur "0", ce qui provoque le blocage du transistor N3, la mise hors service de la branche 22b, le déblocage du transistor P3 et la validation du changement de configuration du dispositif de commutation 10. Compte tenu du niveau atteint par le signal E supérieur au seuil S1 (seuil de déclenchement de la nouvelle configuration), l'état de sortie S est maintenu au niveau "0".

Lors du front descendant du signal E, le dispositif à commutation commute lorsque le niveau du signal E prend la valeur de seuil de déclenchement S1 pour porter la sortie S au niveau "1". Ici encore, compte tenu de la valeur assez élevée du seuil S1 proche du niveau "haut" du signal E, le déclenchement du dispositif de commutation 10 intervient de façon précoce au passage du front descendant du signal E. Lorsque le niveau de tension VBD est atteint par le signal E (après passage au niveau S2) le circuit pilote 16 bascule pour porter la sortie 24 au niveau "1".

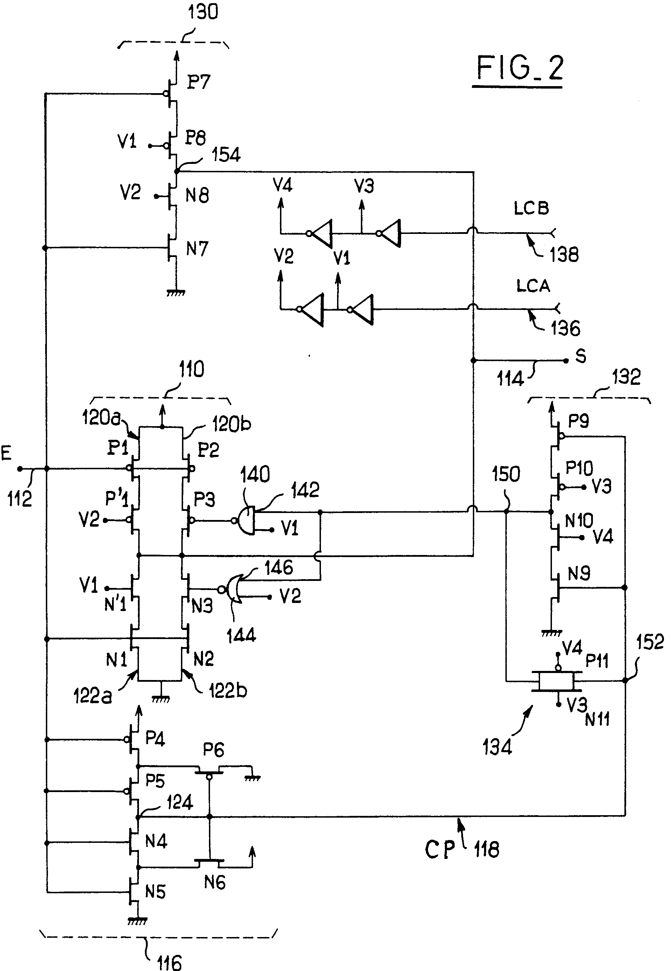

Le circuit à seuil qui vient d'être décrit fonctionne en mode précoce. Sans sortir du cadre de l'invention, la mise en place sur la ligne de commande 18 d'un inverseur de signal inverse l'activation des deux configurations du dispositif de commutation 10. Il en résulte un déclenchement sur le seuil élevé S1 lors du front montant du signal E et un déclenchement sur le seuil bas S2 lors du front descendant du signal E. Le circuit fonctionne alors en mode tardif. Le circuit illustré dans la figure 2 montre, entre autres choses, un exemple d'application de cette variante de l'invention.

Le circuit à seuil illustré dans la figure 2 reprend l'essentiel des caractéristiques techniques du circuit illustré dans la figure 1. Les éléments du circuit de la figure 2 identiques ou semblables à certains éléments du circuit de la figure 1 portent les mêmes chiffres de référence, augmentés de 100, et ne seront pas décrits à nouveau en détails. Si l'on considère la figure 2, on remarque un dispositif de commutation à seuil 110 à deux configurations, analogue à celui décrit en référence à la figure 1, et un circuit de pilotage 116 à hystérésis, constitué par une bascule de Schmitt identique à celle décrit en référence à la figure 1. A ces deux sous-ensembles de base sont associés d'une part un amplificateur à seuil centré 130 monté en parallèle avec le dispositif de commutation 110 entre l'entrée E 112 et la sortie S 114 et, d'autre part, un circuit inverseur 132 et un circuit

4

interrupteur 134 montés en parallèle sur la ligne de commande de pilotage CP 118 entre les jonctions 150 et 152. La jonction 150 est connectée à deux portes 140 et 144 présentées ultérieurement, tandis que la jonction 152 est connectée à la sortie 124 du circuit de pilotage 116. Enfin, le circuit à seuil est muni de deux lignes de commande LCA 136 et LCB 138, chacune équipée d'un montage série de deux inverseurs susceptibles de délivrer en sortie deux signaux de commande de tensions opposées respectivement V1, V2 et V3, V4. Ces signaux de commande sont transmis aux divers points d'entrée V1, V2, V3, V4 comme représenté sur la figure 2. La ligne de commande LCA 136 a pour objet de mettre en service sélectivement soit le dispositif de commutation 110, soit le dispositif à seuil 130. La ligne de commande LCB 138 a pour objet de placer sélectivement le dispositif de commutation 110 soit en mode précoce soit en mode tardif. D'une façon pratique, l'utilisateur est ainsi en mesure de choisir le mode opératoire du circuit à seuil de la figure 2, (précoce, centré ou tardif) selon les conditions d'utilisation de celui-ci. Le mode centré pourra' être retenu dans le cas où le signal d'entrée présente des oscillations parasites d'amplitude suffisamment élevée pour déclencher des commutations indésirables sur la sortie S en fonctionnement en mode précoce.

Si l'on considère à nouveau la figure 2, le dispositif de commutation 110 est pourvu, sur la branche 120a, d'un transistor PMOS P'1 faisant fonction d'interrupteur et dont la grille est commandée par le signal V2 délivré par LCA et, sur la branche 122a, d'un transistor NMOS N'1 faisant fonction d'interrupteur et dont la grille est commandée par le signal V1 délivré par LCA. Par ailleurs, le transistor de configuration P3 est commandé par une porte NON-ET 140 dont une entrée 142 est connectée à la jonction 150 de la ligne CP 118 (en aval de l'inverseur 132 et de l'interrupteur 134) et dont l'autre entrée reçoit le signal V1. De façon similaire, le transistor de configuration N3 est commandé par une porte NON-OU 144 dont une entrée 146 est connectée à la jonction 150 de la ligne CP 118 (en aval de l'inverseur 132 et de l'interrupteur 134) et dont l'autre entrée reçoit le signal V2.

Tel qu'illustré dans la figure 2, l'amplificateur à seuil 130 se compose d'un montage série de deux transistors PMOS P7 et P8 disposés entre la source de tension VDD et la sortie 154 de l'amplificateur 130 (connectée à la ligne de sortie S 114 du circuit à seuil) et d'un montage série de deux transistors NMOS N7 et N 8 disposés entre la sortie 154 et la masse. Les transistors P7 et N7 ont leurs grilles connectées à l'entrée 112 du circuit pour recevoir le signal E tandis que les transistors P8 et N8 font fonction d'interrupteurs de mise en/hors service de l'amplificateur 130. Pour ce faire, les grilles des transistors P8 et N8 reçoivent respectivement les signaux de tension V1 et V2. Lorsque la ligne de commande LCA 136 est activée au niveau "1" (V1="0" et V2="1"), les transistors P8 et N8 sont passants. L'amplificateur 130 est en service et fonctionne comme un inverseur classique, le choix des caractéristiques des divers transistors P7, N7, P8 et N8 étant tel que le seuil de déclenchement de l'amplificateur 130 soit centré (c'est-à-dire avec déclenchement de l'amplificateur sur front montant ou descendant pour un niveau de seuil situé environ à mi-hauteur entre les niveaux "bas" et "haut" du signal E). Par ailleurs, la mise au niveau "1" de la ligne de commande LCA 136 met hors service le dispositif à commutation à seuils multiples 110. En effet, P'1 et N'1 sont bloqués, leur tension de grille étant respectivement portée à V2="1" et V1="0". De plus, la sortie de la porte NON-ET 140 est portée au niveau "1" par la mise au niveau "0" de l'entrée V1 de cette même porte, quel que soit l'état de l'entrée 142. De même, la sortie de la porte NON-OU 144 est portée au niveau "0" par la mise au niveau "1" de l'entrée V2 de cette même porte, quel que soit l'état de l'entrée 146. Ainsi, dans ce mode opératoire du circuit à seuil où V1="0" et V2="1", tous les transistors P'1, N'1, P3 et N3 sont bloqués. On peut remarquer pour finir que la ligne LCA 136 commande le jeu d'interrupteurs constitué par les transistors P'1, N'1, P3, N3, P8 et N8.

A l'inverse, la mise hors service de l'amplificateur 130 et la mise en service du dispositif de commutation 110 est obtenue par la mise au niveau "0" du signal sur la ligne de commande LCA 136. Dans ce cas, la tension V1 = "1" et la tension V2 = "0", ce qui entraîne le blocage des transistors P8 et N8 (l'amplificateur 130 est alors hors service) et la mise à l'état conducteur des transistors P'1 et N'1. Le mode opératoire (précoce ou tardif) du dispositif 110 dépend du degré d'inversion du signal de commande entre la sortie 124 du circuit pilote 116 et les grilles des transistors de commutation P3 et N3, c'est-à-dire de l'état d'activation du circuit inverseur 132 et de l'interrupteur 134 en fonction du signal de commande LCB. Plus précisément, le circuit inverseur 132 est de structure sensiblement identique à l'amplificateur 130, ayant un montage série de deux transistors PMOS P9 et P10 disposés entre la source de tension VDD et la sortie 150 du circuit 132 (connecté à l'entrée 142 de la porte NON-ET 140 et à l'entrée 146 de la porte NON-OU 144) et d'un montage série de deux transistors NMOS N9 et N10 disposés entre la sortie 150 et la masse du circuit. Les transistors P9 et N9 ont leurs grilles connectées par la jonction 152 à la sortie 124 du circuit de pilotage 116 tandis que les transistors P10 et N10 font fonction d'interrupteurs de mise en/hors service de circuit inverseur 132. Pour ce faire, les grilles de transistors P10 et N10 reçoivent respectivement les signaux de tension V3 et V4. Comme pour l'amplificateur 130, le choix des caractéristiques des divers transistors P9 et N9, P10 et N 10 est tel que le seuil de déclenchement du circuit inverseur 132 soit centré. Par ailleurs, l'interrupteur 134 est constitué des deux transistors PMOS P11 et NMOS N11 montés en parallèle entre les jonctions 150 et 152 et dont les grilles reçoivent respectivement les signaux de tension V4 et V3.

Par conséquent, lorsque la ligne de commande LCB 136 est portée au niveau "1", V3="0" et V4="1". Cette ligne LCB commande le jeu d'interrupteurs constitué par les transistors P10, N10, P11 et N11. Il en résulte que les deux transistors P11 et N11 sont bloqués tandis que les deux transistors P10 et N10 sont à l'état passant (le circuit inverseur 132 étant alors en service). Lorsque le niveau de tension de la sortie 124 du circuit de pilotage 116 est à "1", (pour E="0", puis jusqu'au déclenchement du circuit 116 en fin de front montant du signal E), le niveau de tension à la jonction 150 est à "0". Il en résulte d'une part que l'état de sortie de la porte NON-ET 140 est à "1", bloquant le transistor de configuration P3 et d'autre part que l'état de sortie de la porte NON-OU 144 est à "1", rendant conducteur le transistor de configuration N3. Le dispositif de commutation 110 présente alors la configuration "seuil bas" décrite précédemment avec un seuil de déclenchement au niveau S2 lors du passage du front montant du signal E. Après le basculement du circuit de pilotage 116 (en fin de front montant du signal E), la sortie 124 passe au niveau de tension "0" et la jonction 150 au niveau de tension "1". Il en résulte la mise au niveau "0" de la sortie de la porte NON-ET 140 (et la mise à l'état conducteur du transistor de configuration P3) et la mise au niveau "1" de la sortie de la porte NON-OU 144 (et le blocage du transistor N3). Le dispositif de commutation 110 présente alors la configuration "seuil haut" décrite précédemment avec un seuil de déclenchement au niveau S1 lors du passage du front descendant du signal E.

On remarque ainsi que pour le niveau de tension "1" de la ligne de commande LCB 138, le dispositif de commutation 110 fonctionne en mode opératoire précoce, ce qui est conforme avec le fonctionnement du dispositif de commutation 10 car la ligne de commande 118 présente deux étages de circuits inverseurs du signal de commande CP (l'inverseur 132 associé à la porte NON-ET 140 ou l'inverseur 132 associé à la porte NON-OU 144). La mise au niveau "0" de la ligne de contrôle LCB 138 entraîne le blocage des transistors P10 et N10 (et par là-même la mise hors service du circuit inverseur 132) et la mise à l'état conducteur des transistors P11 et N11. Le dispositif de commutation 110 fonctionne alors selon les configurations inversées, c'est-à-dire en mode tardif.

L'invention est donc bien adaptée à la technologie des circuits intégrés utilisant des transistors à effet de champ. A titre illustratif, la réalisation pratique du circuit illustré dans la figure 2 en technologie CMOS de longueur électrique de grille de 0,7 micromètre a attribué aux différents transistors les largeurs électriques suivantes, données en micromètres :

P1, P'1    35
P2, P3    144
N1, N'1    14
N2, N3    59
P4, P5    10
N4, N5    4
P6    34
N6    12
P7, P8    144
N7, N8    59
P9, P10    30
N9, N10    12
P11    25
N11    10,5

D'une manière générale, la configuration du dispositif de commutation 10, 110 peut être faite en activant sélectivement les branches et/ou directement les transistors. Plus de deux branches pourraient être prévues. Le nombre de combinaisons de la sélection déterminerait alors le nombre de seuils que pourrait prendre le dispositif de commutation. Dans l'exemple illustré, le dispositif de commutation est avantageusement du type inverseur à transistors à effet de champ complémentaires. Les valeurs de seuil sont déterminées par les rapports correspondants des largeurs électriques équivalentes des grilles des transistors de l'inverseur. Les largeurs électriques de grille se combinent dans les branches parallèles pour correspondre à une largeur électrique de grille équivalente. Les transistors se combinent en effet comme des résistances électriques. Cependant, la description précédente fait clairement ressortir que le principe de l'invention n'est pas limité à ce type de dispositif de commutation et à cette forme de détermination des valeurs de seuil.

## Revendications

1.    Circuit à seuil comprenant un dispositif de commutation à seuils multiples (10, 110), caractérisé en que le dispositif de commutation à seuils multiples comprend une pluralité de transistors de déclenchement PMOS (P1, P2) commandés par le signal d'entrée (E) et montés en parallèle sur un premier jeu de branches (20a, 120a, 20b, 120b) disposées entre une source de tension (VDD) et la sortie S (14, 114) dudit circuit à seuil, au moins une (20b, 120b) des branches du premier jeu étant pourvue d'un transistor de configuration PMOS (P3) commandé par un circuit pilote (16, 116), et une pluralité de transistors de déclenchement NMOS (N1, N2) commandés par le signal d'entrée (E) et montés en parallèle sur un second jeu de branches (22a, 122a, 22b, 122b) disposées entre la masse du circuit et la sortie S (14, 114) dudit circuit à seuil, au moins une (22b, 122b) des branches du second jeu étant pourvue d'un transistor de configuration NMOS (N3) commandé par le circuit pilote (16, 116).

2. Circuit à seuil selon la revendication 1, caractérisé en ce que les valeurs de seuil sont déterminées par les rapports respectifs des largeurs électriques équivalentes des grilles des transistors à effet de champ du dispositif de commutation.

3. Circuit à seuil selon la revendication 1 ou 2, caractérisé en ce que le circuit pilote (16, 116) est commandé par le signal d'entrée (E).

4. Circuit à seuil selon la revendication 3, caractérisé en ce que le circuit pilote (16, 116) est du type à hystérésis, notamment du type à bascule de Schmitt.

5. Circuit à seuil selon la revendication 4, caractérisé en ce que le circuit pilote (16, 116) bascule au passage du front montant (FM) du signal d'entrée (E) sur le seuil "haut" (VBM) supérieur au plus haut (S1) des seuils de déclenchement dudit dispositif de commutation à seuils multiples (10, 110) et au passage du front descendant (FD) du signal d'entrée (E) sur le seuil "bas" (VBD) inférieur au plus bas (S2) des seuils de déclenchement dudit dispositif de commutation à seuils multiples.

6. Circuit à seuil selon l'une des revendications 1 à 5, caractérisé en ce que le signal de sortie (CP) du circuit pilote (116) est appliqué sur les grilles des transistors MOS complémentaires d'un inverseur (132) et en ce qu'il comporte des premiers moyens interrupteurs (P10, N10, P11, N11) commandés pour appliquer sur les transistors de configuration soit le signal de sortie (CP) du circuit pilote (116), soit le signal de sortie de l'inverseur (132).

7. Circuit à seuil selon l'une des revendications 1 à 6, caractérisé en ce qu'il comporte un dispositif à seuil centré (130) recevant le signal d'entrée (E) et ayant une sortie connectée à la sortie (S) dudit circuit à seuil et des seconds moyens interrupteurs (140, 144, P'1, N'1, P8, N8) commandés pour mettre en service sélectivement le dispositif de commutation à seuils multiples ou le dispositif à seuil centré.

8. Circuit à seuil selon la revendication 6 ou 7, caractérisé en ce que les premiers moyens interrupteurs comprennent un premier interrupteur formé de deux transistors MOS complémentaires (P10, N10) respectivement montés en série avec les deux transistors dudit inverseur (132) et commandés par deux tensions de commande opposées (V3, V4).

9. Circuit à seuil selon la revendication 6, 7 ou 8, caractérisé en ce que les premiers moyens interrupteurs comprennent un second interrupteur (134) reliant la sortie du circuit pilote (116) aux grilles des transistors de configuration (P3, N3) et formé de deux transistors MOS complémentaires (P11, N11) montés en parallèle et commandés par deux tensions de commande opposées (V3, V4).

10. Circuit à seuil selon la revendication 7, 8 ou 9, caractérisé en ce le circuit à seuil centré est un second inverseur fait d'une paire de transistors MOS complémentaires (P7, N7) et les seconds moyens interrupteurs comprennent un troisième interrupteur formé de deux transistors MOS complémentaires (P8, N8) respectivement montés en série avec la paire de transistors dudit second inverseur et commandés par deux tensions de commande opposées (V1, V2).

11. Circuit à seuil selon l'une des revendications 7 à 10, caractérisé en ce que les seconds moyens interrupteurs comprennent un quatrième interrupteur formé de deux transistors MOS complémentaires (P'1, N'1) respectivement montés en série avec les transistors MOS complémentaires (P1, N1) dans lesdits premier et second jeux de branches dudit dispositif de commutation à seuils multiples (110) et commandés par deux tensions de commande opposées (V1, V2).

**12.** Circuit à seuil selon l'une des revendications 7 à 11, caractérisé en ce que les seconds moyens interrupteurs comprennent un cinquième interrupteur commandé pour inactiver les transistors de configuration (P3, N3).

**13.** Circuit à seuil selon la revendication 12, caractérisé en ce que le cinquième interrupteur comprend une porte NON-ET (140) et une porte NON-OU (144) ayant deux bornes d'entrée respectivement connectées à la sortie de l'inverseur (132) et à deux tensions de commande opposées (V1, V2) et leurs bornes de sortie respectivement connectées aux grilles des deux transistors de configuration (P3, N3).

FIG.1

FIG_2

EP 0 497 068 A1

**Office européen des brevets**

**RAPPORT DE RECHERCHE EUROPEENNE**

Numero de la demande

EP 91 40 3333

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | US-A-4 506 168 (UYA) * Colonne 2, lignes 6-55; colonne 4 - colonne 5, ligne 9; figure 7 * | 1,2 | H 03 K 17/30 H 03 K 3/353 |
| Y | | 3,4,7,8,10,11 | |
| X | US-A-4 612 466 (STEWART) * Colonne 2, ligne 68 - colonne 6, ligne 52; figure 1 * | 1 | |
| A | | 6 | |
| Y | PATENT ABSTRACTS OF JAPAN, vol. 8, no. 139 (E-253)[1576], 28 juin 1984; & JP-A-59 47 830 (NIPPON DENKI K.K.) 17-03-1984 * Résumé * | 3,4 | |
| Y | PATENT ABSTRACTS OF JAPAN, vol. 8, no. 66 (E-234)[1503], 28 mars 1984; & JP-A-58 215 134 (MITSUBISHI DENKI K.K.) 14-12-1983 * Résumé * | 7,8,10,11 | DOMAINES TECHNIQUES RECHERCHES (Int. Cl.5) H 03 K |

Le présent rapport a été établi pour toutes les revendications

| Lieu de la recherche | Date d'achèvement de la recherche | Examinateur |
|---|---|---|
| LA HAYE | 20-03-1992 | CANTARELLI R.J.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

11